# FASCICULE DE BREVET EUROPEEN

(11) **EP 2 073 190 B1**
(45) Date de publication et mention de la délivrance du brevet: **23.12.2015**
(21) Numéro de dépôt: 08354082.3
(22) Date de dépôt: 06.11.2008
(51) Int. Cl.: G02F 1/1335, H01L 21/77, G09G 3/32

(54) **Dispositif d'affichage comportant des filtres colorés et des éléments photoémissifs alignés électroniquement**
Anzeigevorrichtung, die Farbfilter und elektronisch ausgerichtete Fotoemissionselemente umfasst
Display device comprising coloured filters and electronically aligned light-emitting elements

(30) Priorité: 21.12.2007 FR 0709014
(43) Date de publication de la demande: 24.06.2009
(73) Titulaire: Commissariat à l'Énergie Atomique et aux Énergies Alternatives, 75015 Paris (FR)
(72) Inventeur: Mourey, Bruno, 38500 Coublevie (FR)
(74) Mandataire: Hecké, Gérard

(56) Documents cités:
- EP-A- 0 845 770
- EP-A- 1 845 514
- US-A- 6 091 382
- US-A1- 2006 214 596

## Description

### Domaine technique de l'invention

L'invention est relative à un dispositif d'affichage, à base d'une matrice de pixels, chaque pixel comportant une pluralité de sous-pixels organisés au sein dudit pixel suivant au moins une direction d'organisation avec un pas prédéterminé, chaque sous-pixel comportant un filtre coloré disposé, avec le même pas, en regard d'au moins un élément photoémissif, une zone opaque séparant les filtres colorés, le dispositif comportant un circuit de commande d'alimentation des éléments photoémissifs.

### État de la technique

Les dispositifs d'affichage comportent, de manière classique, une matrice de pixels de couleur indépendants qui sont constitués chacun par une pluralité de sous-pixels de couleurs élémentaires. Chaque sous-pixel de couleur élémentaire représente donc un élément émissif fournissant de la lumière dans une couleur prédéfinie. Ce type de dispositif est réalisé, par exemple, au moyen d'une matrice de diodes électroluminescentes organiques colorées qui constituent chacune un sous-pixel.

Pour les dispositifs d'affichage de petite taille et/ou avec une résolution élevée, c'est-à-dire, typiquement pour des pixels ayant un pas inférieur à 50µm, le procédé de fabrication des diodes électroluminescentes organiques ne permet pas la réalisation de sous-pixels de teintes différentes.

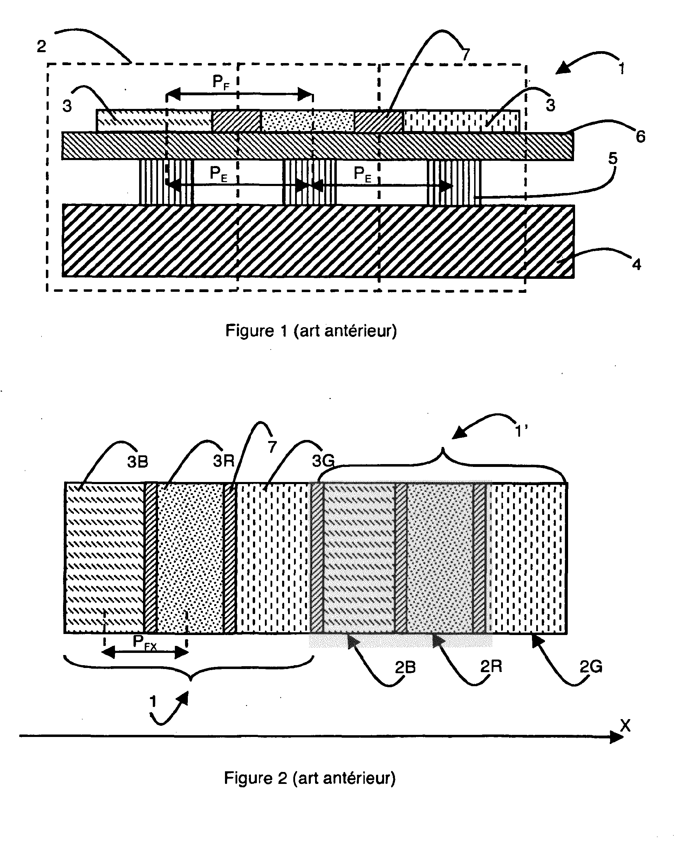

Pour ces dispositifs d'affichage, la formation des sous-pixels de couleur est alors réalisée en associant des diodes électroluminescentes émettant une couleur blanche avec une matrice de filtres colorés. Comme illustré à la figure 1, le dispositif d'affichage comporte, de manière classique, une matrice de pixels 1 organisés en lignes et en colonnes. Chaque pixel 1 est constitué par une pluralité de sous-pixels 2 de couleur, par exemple des sous-pixels bleus, verts, rouges et blancs. De manière conventionnelle, la matrice de pixels 1 et donc la matrice de sous-pixels 2 sont réalisées en disposant une matrice de filtres colorés 3 au-dessus d'un substrat 4 supportant une pluralité d'éléments photoémissifs 5. Chaque filtre coloré 3 appartient à un sous-pixel 2 et le pas des sous-pixels est donc identique à celui (P_{F}) des filtres colorés.

Les éléments photoémissifs 5 sont constitués par tout élément capable d'émettre un rayonnement lumineux et d'être intégré avec la densité d'intégration requise. Les éléments photoémissifs 5 sont, par exemple, des diodes électroluminescentes organiques formées, de manière classique, sur le substrat 4, par exemple par un empilement continu de couches organiques disposées entre deux électrodes : une cathode spécifique à chaque sous-pixel et une anode en général continue. Les éléments photoémissifs 5 émettent tous la même couleur, de préférence une lumière blanche, ce qui permet l'obtention d'un pas de répétition entre les diodes inférieur à 50µm. La matrice de filtres colorés 2 est réalisée par toute technique adaptée, par exemple par photolithographie sur un substrat transparent 6, puis assemblée par exemple à l'aide de colle sur le substrat 4.

A l'intérieur d'un pixel 1, différentes organisations de sous-pixels 2 sont possibles, indépendamment de l'organisation des pixels. Un sous-pixel 2 étant associé à un filtre coloré 3, à chaque organisation de sous-pixels correspond la même organisation de filtres colorés. Au sein du pixel 1, les filtres colorés 3 peuvent être organisés selon une ou deux dimensions, c'est-à-dire selon une droite ou un plan.

Dans des pixels 1 et 1', un exemple d'organisation unidimensionnelle des filtres colorés 3, disposés en bandes côte à côte (organisation dite de type « stripe », est illustré à la figure 2. Dans cette organisation, trois sous-pixels 2R, 2G, 2B et les filtres colorés 3R, 3G, 3B correspondant forment des bandes adjacentes de couleur, qui sont disposées côte à côte, avec un pas P_{FX}, selon une seule direction d'organisation, en ligne (selon l'axe X sur la figure 2) ou en colonne. Les filtres colorés, 3R, 3B et 3G, sont avantageusement rectangulaires avec leur plus petit côté, parallèle à la direction d'organisation (axe X sur la figure 2), définissant le pas (P_{FX}) des filtres colorés 3.

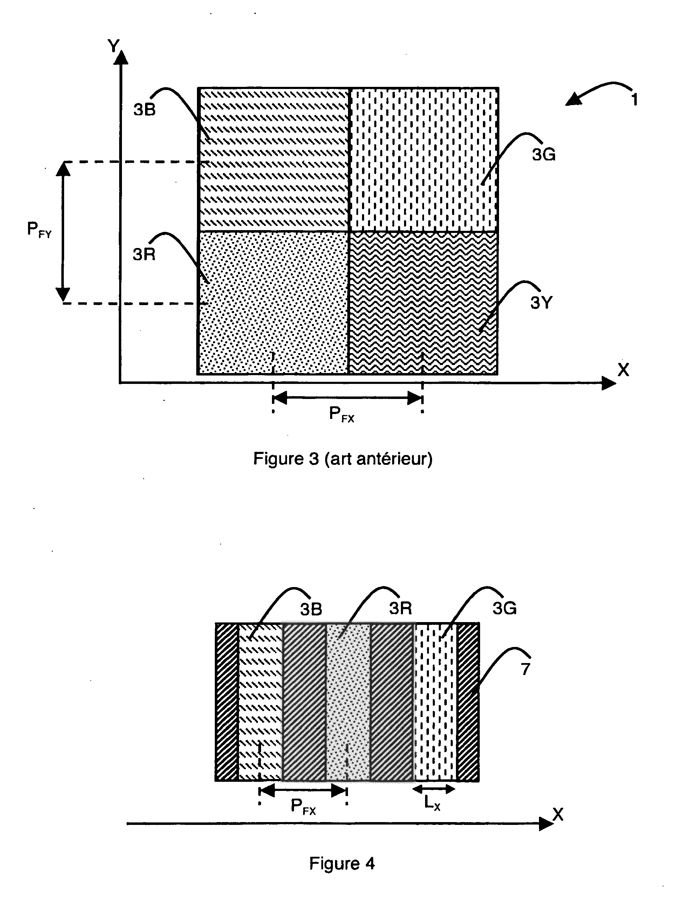

Un exemple d'organisation bidimensionnelle des filtres colorés 3 est représenté par une organisation en matrice carrée (« quad », figure 3). Dans cette organisation, quatre filtres colorés 3R, 3B, 3G, 3Y de chaque pixel sont disposés en carré (figure 3) avec des pas P_{FX} et P_{FY}, dans un plan défini suivant deux directions (axes X et Y perpendiculaires). Avantageusement, les filtres colorés sont de forme carrée.

Le pas P_{E} des éléments photoémissifs 5 est identique au pas P_{F} des filtres colorés 3 dans chacune des directions d'organisation (P_{EX}=P_{FX} et P_{EY}=P_{FY}). La mise en place de la matrice de filtres colorés 3 au-dessus des éléments photoémissifs 5 est alors réalisée avec toute technique d'alignement classique.

L'utilisation de filtres colorés présente l'avantage de n'avoir à former qu'un seul type de diode organique électroluminescente sur le substrat, ce qui facilite le procédé de réalisation et permet l'obtention d'une densité d'intégration élevée.

Cependant, cette approche nécessite d'aligner parfaitement la matrice de filtres colorés par rapport au substrat supportant les diodes électroluminescentes organiques. Or, les machines d'alignement de substrats ont typiquement des précisions d'alignement de l'ordre du micron. Pour palier à tout désalignement et ainsi éviter tout mélange d'information entre les différents sous-pixels, il est nécessaire de prévoir des marges de sécurités entre les sous-pixels. Des zones opaques 7 sont alors disposées entre les filtres colorés. Ces zones opaques 7 sont classiquement réalisées à l'aide d'un élément réfléchissant ou avantageusement au moyen d'un filtre absorbant avec des colorants noirs ou par une couche métallique absorbante, par exemple en chrome, en oxyde de chrome, ou un cermet chrome/SiO₂. La taille de ces zones opaques est du même ordre de grandeur que la précision des machines utilisées, typiquement de un à deux microns. De ce fait, quand le pas de répétition des matrices de pixels diminue, la proportion de la surface occupée par la zone opaque augmente et le signal diminue.

Les documents US2006/0214596 et US6091382 décrivent une matrice de pixels de couleurs où chaque pixel comporte une pluralité de sous-pixels formés par l'association d'un émetteur de lumière et d'un filtre coloré.

### Objet de l'invention

L'invention définie dans les revendications 1 à 8 a pour objet un dispositif d'affichage qui soit facile à mettre en oeuvre, de petite dimension et/ou de résolution élevée en relâchant les contraintes sur les procédés d'alignement.

Le dispositif selon l'invention est caractérisé par les revendications annexées et plus particulièrement par le fait que chaque sous-pixel comporte au moins deux éléments photoémissifs et en ce que les éléments photoémissifs ont un pas de répétition deux fois plus petit que le pas des filtres colorés dans chacune des directions d'organisation du pixel, la dimension de chaque filtre coloré étant inférieure ou égale à la dimension de l'élément photoémissif dans ladite direction, le circuit de commande comportant des moyens de sélection des éléments photoémissifs situés en regard de chaque filtre coloré d'un pixel.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, en coupe, de façon schématique, un pixel d'un dispositif selon l'art antérieur,
- les figures 2 et 3 représentent, en vue de dessus, différentes organisations de filtres colorés au sein d'un pixel d'un dispositif selon l'art antérieur,
- les figures 4 et 5 représentent, en vue de dessus, différentes organisations de filtres colorés au sein d'un pixel d'un dispositif selon l'invention,
- les figures 6 et 7 représentent, en vue de dessous, deux désalignements selon un axe X entre les filtres colorés et des éléments photoémissifs d'un pixel selon la figure 4,
- les figures 8 et 9 représentent deux modes de réalisation d'un circuit de commande d'un dispositif selon l'invention,
- la figure 10 représente, en vue de dessous, l'alignement respectivement pour un pixel selon la figure 5.

### Description d'un mode de réalisation préférentiel de l'invention

Au sein d'un pixel 1, selon les dimensions respectives des filtres colorés 3 et des éléments photoémissifs 5 et selon la précision des moyens d'alignement, le désalignement peut être selon une seule direction, par exemple suivant l'axe X, ou selon deux directions c'est-à-dire suivant les axes X et Y.

Un pixel 1 ayant une organisation unidimensionnelle de ses filtres colorés 3, c'est-à-dire ayant des filtres colorés alignés côte à côte le long d'un axe X (figure 2), n'est sujet qu'à un désalignement suivant une seule direction, la direction (axe X) suivant laquelle sont organisés ses sous-pixels 2. Par ailleurs, un pixel 1 ayant une organisation bidimensionnelle de ses filtres colorés 3 est, de manière classique, sujet à un désalignement suivant deux directions.

Les matrices de filtres colorés et d'éléments photoémissifs ont la même organisation générale, en bande, en triangle ou en matrice carrée, qui tient compte de la matrice de pixels et de l'organisation des sous-pixels à l'intérieur de ces pixels.

Pour s'affranchir des contraintes relatives à l'alignement entre la matrice de filtres colorés 3 et la matrice d'éléments photoémissifs 5, les éléments photoémissifs 5 présentent un pas de répétition (P_{E}) qui est deux fois plus petit que le pas de répétition (P_{F}) des filtres colorés 5 dans chacune des directions d'organisation des filtres colorés au sein du pixel (P_{FX}=2P_{Ex} et P_{FY}=2P_{EY}). Il y a donc, dans chaque direction d'organisation du pixel, deux fois plus d'éléments émissifs 5 que de filtres colorés 3.

Ainsi, pour un pixel ayant une organisation unidimensionnelle, dans laquelle les filtres colorés 3R, 3B, 3G ne sont disposés que suivant la direction X, il y a donc deux éléments photoémissifs 5 par sous-pixel 2. De manière analogue, pour une organisation bidimensionnelle de type matrice carrée, dans laquelle, les filtres colorés 3 sont disposés en carré suivant deux directions X et Y, il y a donc quatre éléments photoémissifs 5 par sous-pixel 2.

De plus, les filtres colorés 3 ont, dans chacune des directions d'organisation du pixel 1, une dimension inférieure ou égale à la dimension correspondante des éléments photoémissifs. Ainsi, comme les filtres colorés 3 ont un pas P_{F} supérieur à celui P_{E} des éléments photoémissifs 5, les filtres colorés 3 ne sont pas jointifs. Il existe alors, autour des filtres colorés 3 adjacents, d'un même pixel 1 ou de deux pixels adjacents, une zone non colorée qui les sépare et à travers laquelle une émission lumineuse parasite pourrait se produire. Afin d'éviter cette émission lumineuse parasite, cette zone 7, située autour des filtres colorés 3, est rendue opaque par absorption ou réflexion du rayonnement lumineux émis, par tout moyen approprié, de préférence au moyen d'un film absorbant similaire à celui utilisé pour la réalisation des dispositifs de l'art antérieur. La zone 7 peut être réalisée au moyen d'un filtre absorbant avec des colorants noirs ou par une couche métallique absorbante, par exemple en chrome, en oxyde de chrome, ou un cermet chrome/SiO₂.

Les filtres colorés 3 ayant un pas P_{F} deux fois supérieur à celui P_{E} des éléments photoémissifs 5, la dimension L de la zone absorbante (dans la direction d'organisation considérée) est supérieure ou égale à celle d'un filtre coloré 3. En d'autres termes, la dimension L du filtre coloré 3 dans chacune des directions d'organisation est toujours inférieure ou égale à la moitié du pas P_{F} des sous-pixels 2 dans cette même direction.

Dans une organisation unidimensionnelle, illustrée à la figure 4, dans laquelle les filtres colorés 3 du pixel sont disposés côte à côte suivant l'axe X, la zone opaque 7 est disposée de part et d'autre de chaque filtre coloré 3 et la largeur L_{X} de chaque filtre coloré est telle que : 2L_{X} ≤ P_{FX}.

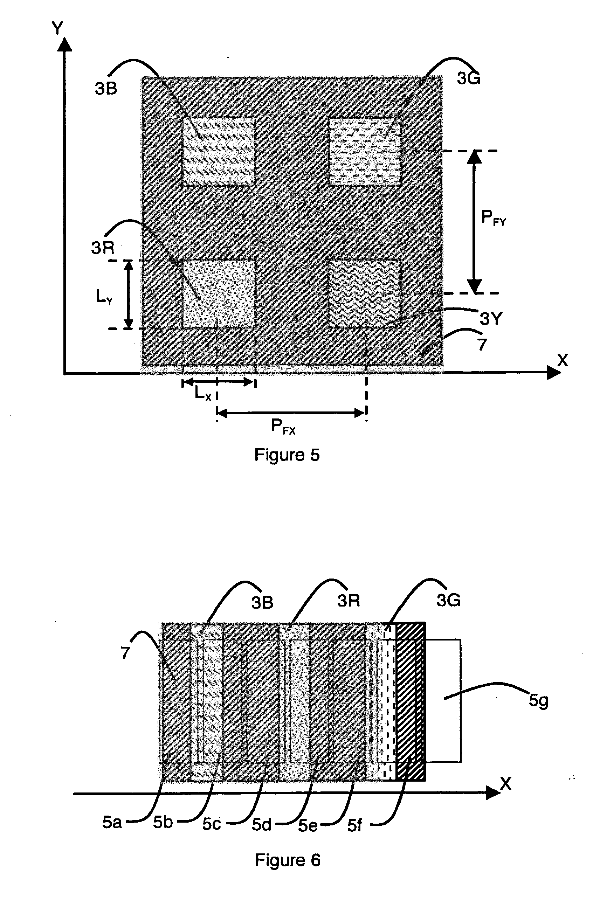

Dans une organisation bidimensionnelle de type matrice carrée, illustrée à la figure 5, les filtres colorés 3 sont disposés en carré dans un plan X,Y. Dans chacune des deux directions utilisées (X, Y), la dimension L du filtre coloré 3 est au moins deux fois inférieure au pas P_{F} des sous-pixels 2 dans la direction considérée. Ainsi, 2L_{X} ≤ P_{FX} et 2L_{Y} ≤ P_{FY}. La zone opaque 7 remplit alors toute la surface du pixel qui entoure les filtres colorés 3.

Dans tous les cas, la matrice de filtres colorés comporte, par exemple des filtres de couleur bleu, vert et rouge (3B, 3G, 3R) séparés par une zone opaque 7, qui peut être réalisée par exemple par photolithographie avant, pendant ou après la réalisation des filtres colorés.

Les filtres colorés 3 et les éléments photoémissifs 5 ayant des pas de répétition (P_{F}, P_{E}) différents, chaque sous-pixel 2 comporte alors une pluralité d'éléments photoémissifs 5 disposés en regard d'un filtre coloré 3. Il est donc nécessaire de contraindre le fonctionnement simultané des différents éléments photoémissifs 5 associés à un sous-pixel 2.

Dans une organisation unidimensionnelle, chaque sous-pixel 2 comporte un filtre coloré 3 associé à deux éléments photoémissifs 5. Les sous-pixels d'extrémité peuvent éventuellement ne comporter qu'un seul élément photoémissif 5. Tous les éléments photoémissifs sont identiques et disposés côte à côte selon l'axe X, avec un pas P_{EX}.

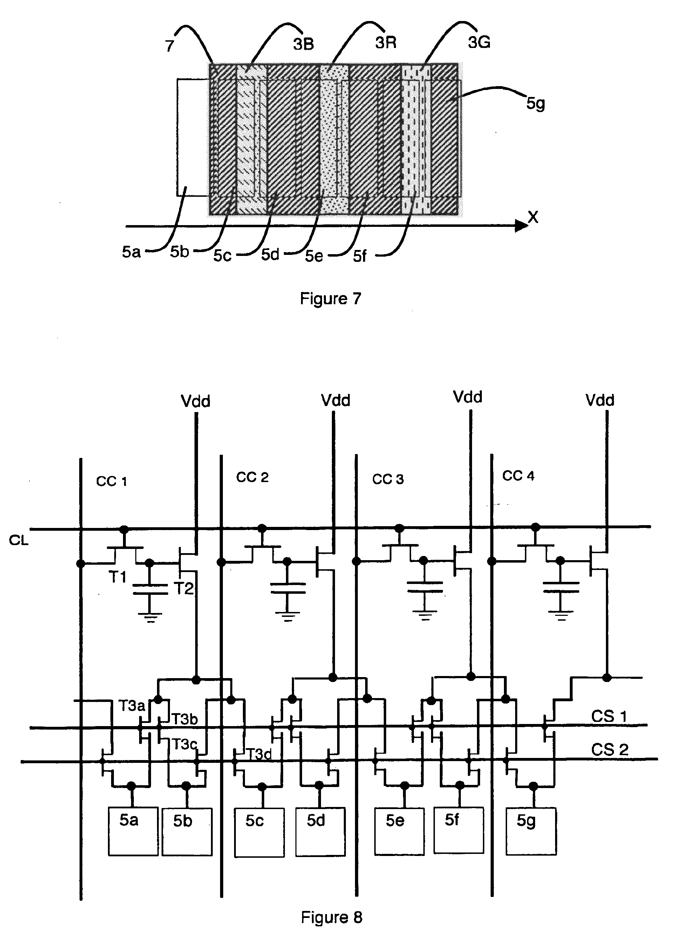

Les figures 6 et 7 illustrent deux désalignements différents entre les trois filtres colorés 3 d'un pixel 1 et les sept éléments photoémissifs adjacents 5a à 5g. Idéalement, les trois filtres colorés du pixel devraient être alignés avec les six éléments photoémissifs 5a à 5f. Un premier désalignement, selon X, est illustré par la figure 6. Dans ce cas, les deux éléments photoémissifs les plus à gauche, 5a et 5b sont en parti recouverts par le filtre 3B. Les deux éléments photoémissifs suivants 5c et 5d sont en parti recouverts par le filtre central 3R et les deux éléments photoémissifs suivants 5e et 5f sont en parti recouverts par le filtre 3G. La zone opaque 7 du pixel 1 recouvre le reste des éléments photoémissifs 5a à 5f.

Dans le désalignement illustré à la figure 6, les éléments photoémissifs 5a et 5b sont ainsi appariés et associés au filtre coloré 3B, les éléments photoémissifs 5c et 5d sont appariés et associés au filtre coloré 3R et les éléments photoémissifs 5e et 5f sont appariés et associés au filtre coloré 3G. L'élément photoémissifs 5g n'est pas associé au pixel considéré, mais à un pixel adjacent, situé à la droite de celui-ci. Une petite partie de l'élément photoémissif 5g est recouverte par la zone opaque du pixel considéré, tandis qu'une partie équivalente à celle de l'élément photoémissif 5a est recouverte par la zone opaque (non représentée) d'un pixel situé à la droite du pixel considéré.

Dans le second désalignement, selon l'axe X, illustré par la figure 7, les éléments photoémissifs 5b et 5c sont en parti recouverts par le filtre 3B, les éléments photoémissifs 5d et 5e par le filtre 3G et les éléments photoémissifs 5f et 5g par le filtre 3R. Dans le désalignement illustré à la figure 7, les éléments photoémissifs 5b et 5c sont appariés et associés au filtre coloré 3B, les éléments photoémissifs 5d et 5e sont appariés et associés au filtre coloré 3R et les éléments photoémissifs 5f et 5g sont appariés et associés au filtre coloré 3G du même pixel. L'élément photoémissif 5a n'est plus, dans ce cas, associé au pixel considéré, mais à un pixel adjacent situé à la gauche de celui-ci.

Ainsi, suivant le désalignement qui existe entre le substrat 4 comportant les éléments photoémissifs 5 et la matrice de filtres colorés 3, le même filtre coloré 3 d'un pixel ne recouvre pas toujours les mêmes éléments photoémissifs 5. Cependant, quel que soit le désalignement, dans la mesure où l'on néglige l'espacement compris entre deux éléments photoémissifs adjacents, chaque filtre coloré est situé en totalité en regard de l'équivalent d'un élément photoémissif ayant les dimensions du filtre coloré considéré. Il est donc inutile d'aligner parfaitement les filtres colorés 3 et les éléments photoémissifs 5. Il est cependant nécessaire de sélectionner les éléments photoémissifs 5 adjacents effectivement recouverts par chaque filtre coloré et qui sont à associer à chaque sous-pixel 2 lors d'une utilisation ultérieure du dispositif. Cette sélection peut être assimilée à un alignement électronique de chaque filtre coloré 3 avec les éléments photoémissifs qu'il recouvre. Ceci est réalisé au moyen d'un circuit de commande d'alimentation des éléments photoémissifs, qui comporte des moyens de sélection des éléments photoémissifs situés en regard de chaque filtre coloré d'un pixel.

Le circuit de commande d'alimentation des éléments photoémissifs, illustré à la figure 8, correspond à une ligne de pixels 1 ayant chacun trois sous-pixels illustrés aux figures 6 et 7. Le circuit de commande comporte une commande de ligne CL qui correspond à la ligne de pixels à alimenter et des commandes de colonne CC (CC1 à CC4 sur la figure 8) qui régissent l'alimentation des différents sous-pixels de cette ligne.

Un premier interrupteur électronique T1 associé à la commande de colonne CC1 est connecté entre la commande de colonne CC1 et l'électrode de contrôle d'un second interrupteur électronique T2. L'électrode de contrôle du premier interrupteur électronique T1 est connectée à la commande de ligne CL.

Chaque commande de colonne CC est connectée à des premier et second interrupteurs électroniques telle que précisée précédemment, les seconds interrupteurs électroniques T2 étant tous connectés à la commande de ligne CL.

Chaque second interrupteur électronique T2 est connecté à une borne d'alimentation Vdd et à quatre troisièmes interrupteurs électronique T3 (T3a à T3d). Chaque troisième interrupteur électronique T3 est lui-même connecté à un élément photoémissif, de sorte que chaque élément photoémissif 5 soit connecté à deux troisièmes interrupteurs électronique T3. Ainsi, l'interrupteur électronique T2 associé à la commande de colonne CC1 est connecté par l'intermédiaire de l'interrupteur électronique T3a à l'élément émissif 5a, des interrupteurs électroniques T3b et T3c à l'élément émissif 5b et par l'intermédiaire de l'interrupteur électronique T3d à l'élément émissif 5c. L'élément photoémissif 5c est également connecté à l'interrupteur électronique T2 associé à la commande de colonne CC2.

Chaque sous-pixel 2 est donc associé à une commande de colonne CC et chaque commande de colonne CC est connectée à trois éléments photoémissifs immédiatement adjacents. Ainsi la commande de colonne CC1 est connectée aux éléments photoémissifs 5a/5b/5c, et les commandes de colonne CC2 et CC3 sont respectivement connectées aux éléments photoémissifs 5c/5d/5e et 5e/5f/5g par l'intermédiaire des interrupteurs électroniques. La commande de colonne CC4 correspond au pixel immédiatement adjacent et est notamment connectée à l'élément photoémissif 5g.

Les éléments émissifs 5 sont associés deux à deux à une commande de colonne CC, par l'intermédiaire de deux commandes de sélection CS1 et CS2 se trouvant dans des états opposés. Les commandes de sélection CS sont connectées selon un schéma prédéfini aux électrodes de contrôle des troisièmes interrupteurs électroniques T3, de manière à associer uniquement deux éléments émissifs 5 adjacents à une même commande de colonne CC.

La commande de sélection CS1 est connectée aux électrodes de contrôle des interrupteurs électroniques T3a et T3b, tandis que la commande de sélection CS2 est connectée aux électrodes de commande des interrupteurs électroniques T3c et T3d. Avantageusement, l'élément émissif 5b est connecté directement à un second interrupteur électronique T2, c'est-à-dire sans les troisièmes interrupteurs électroniques T3b et T3c. Il en va de même des éléments photoémissifs 5d et 5f.

Lorsque la commande de sélection CS1 est dans un état haut, les interrupteurs électroniques T3a et T3b reliant les éléments photoémissifs 5a et 5b à la commande de colonne CC1 sont passants et les interrupteurs électroniques T3c et T3d sont bloqués. Ceci provoque le fonctionnement simultané des éléments photoémissifs 5a et 5b lors de l'application d'un signal de commande de colonne CC1. De manière analogue, le fonctionnement des éléments photoémissifs 5c et 5d dépend alors de l'état de la commande de colonne CC2 et le fonctionnement des éléments photoémissifs 5e et 5f de l'état de la commande de colonne CC3.

Au contraire, lorsque la commande de sélection CS2 est dans un état haut, les interrupteurs électroniques T3c et T3d reliant les éléments photoémissifs 5b et 5c à la commande de colonne CC1 sont passants et les interrupteurs électroniques T3a et T3b sont bloqués. Ceci provoque le fonctionnement simultané des éléments photoémissifs 5b et 5c lors de l'application d'un signal de commande de colonne CC1. De manière analogue, le fonctionnement des éléments photoémissifs 5d et 5e dépend alors de l'état de la commande de colonne CC2 et le fonctionnement des éléments photoémissifs 5f et 5g de l'état de la commande de colonne CC3.

Selon la valeur des signaux de sélection CS1 et CS2, les éléments photoémissifs d'un sous-pixel associé à la commande de colonne CC1 sont donc différents, 5a et 5b si CS1 est à l'état haut, 5b et 5c dans le cas contraire. Ainsi, dans une organisation unidimensionnelle, illustrée par les figures 6 à 8, chaque sous-pixel 2 est constitué par un filtre coloré associé aux deux éléments photoémissifs sélectionnés, connectés à la commande de colonne CC associée au sous-pixel.

Pour choisir la commande de sélection CS à activer, pour que les éléments photoémissifs 5 sélectionnés soient disposés en regard du filtre coloré du sous-pixel correspondant, la détermination du désalignement, entre les filtres colorés et les éléments photoémissifs, est réalisée en passant successivement chacune des commandes de sélection CS1 et CS2 à l'état haut et en contrôlant la qualité de l'image obtenue. La commande de sélection CS correspondant à un désalignement nul est alors maintenue à l'état haut. De cette manière, l'alignement est réalisé électroniquement entre les éléments photoémissifs 5 et les filtres colorés 3.

Si des commandes de sélection CS distinctes sont associées à chaque ligne de pixels, comme illustré à la figure 8, l'alignement électronique est réalisé indépendamment pour chaque ligne du dispositif d'affichage. Un alignement en colonne est également possible si les sous-pixels sont organisés en colonnes.

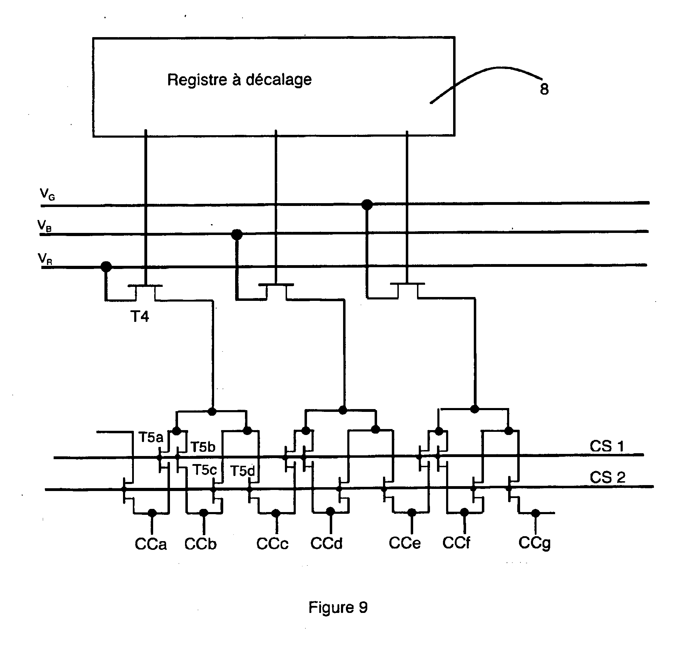

Deux commandes de sélection opposées CS1 et CS2 peuvent également être utilisées pour l'ensemble des lignes ou colonne du dispositif d'affichage ou en variante pour une portion du dispositif d'affichage, c'est-à-dire que le dispositif d'affichage est divisé, par exemple, en deux, trois ou quatre groupes de lignes ou colonnes et que chaque groupe de lignes ou colonne comporte alors deux commandes de sélections. Dans le circuit de commande de la figure 9, la sélection est réalisée entre les signaux vidéo V_{G}, V_{B}, V_{R} correspondant à chaque couleur et les commandes de colonne CC du circuit de commande, chaque commande de colonne étant associé à une colonne d'éléments photoémissifs (figure 9). Ainsi, les commandes de colonne CCa à CCg contrôlent le fonctionnement de tous les éléments photoémissifs respectivement 5a à 5g d'une même colonne du dispositif d'affichage.

Dans le mode de réalisation illustré à la figure 9, un interrupteur électronique T4 connecté entre un signal vidéo (par exemple V_{R}) et quatre interrupteurs électroniques T5a à T5d. Chaque interrupteur électronique T5 est connecté à une commande de colonne correspondante (CCa à CCc pour les interrupteurs électroniques T5a à T5d) contrôlant chacun tous les éléments photoémissifs d'une même colonne. La commande de sélection CS1 est connectée aux électrodes de contrôle des interrupteurs électroniques T5a et T5b, tandis que la commande de sélection CS2 est connectée aux électrodes de contrôle des interrupteurs électroniques T5c et T5d. Ainsi, lorsque la commande de sélection CS1 est activée, le signal vidéo V_{R} est appliqué aux deux commandes de colonne CCa et CCb par l'intermédiaire des interrupteurs électroniques T5a et T5b et contrôle tous les éléments photoémissifs 5a et 5b. Par contre, lorsque la commande de sélection CS2 est activée, le signal vidéo V_{R} est appliqué aux deux commandes de colonne CCb et CCc par l'intermédiaire des interrupteurs électroniques T5c et T5d et contrôle tous les éléments photoémissifs 5b et 5c. De manière analogue, le signal vidéo V_{B} est appliqué sur les commandes de colonne CCc et CCd si CS1 est activé et sur les commandes de colonne CCd et CCe si CS2 est activé. Le signal vidéo V_{G} est appliqué soit aux commandes de colonne CCe et CCf, soit aux commandes de colonne CCf et CCg. Ainsi, lorsque des signaux en provenance d'un registre à décalage 8 sont successivement appliqués sur les électrodes de contrôle des interrupteurs électroniques T4 respectivement associés aux divers signaux vidéo, les éléments photoémissifs sélectionnés sont activés. Avantageusement, les commandes de colonnes CCb, CCd et CCf sont directement reliées au signal vidéo correspondant.

De manière générale, les moyens de sélection des éléments photoémissifs comportent autant de commandes de sélection que le sous-pixel 2 comporte d'éléments photoémissifs 5. Ainsi, dans une organisation bidimensionnelle en matrice carrée (« quad »), chaque sous-pixel comporte quatre éléments photoémissifs 5 avec une gestion du désalignement suivant deux directions. Les moyens de sélection des éléments photoémissifs comportent alors quatre commandes de sélection.

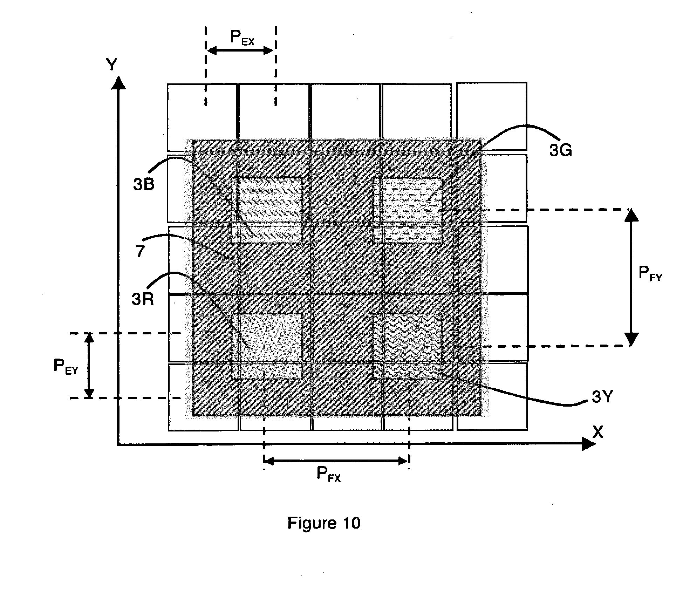

Pour cette organisation bidimensionnelle en matrice carrée, illustrée à la figure 10, les moyens de sélection des éléments photoémissifs sont analogues à ceux décrits dans le cas d'une organisation unidimensionnelle. Cependant, deux commandes de sélection sont alors utilisées pour réaliser l'alignement suivant l'axe X et deux autres commandes de sélection pour l'alignement suivant l'axe Y.

Un premier alignement peut être réalisé selon l'axe X sur l'ensemble des lignes d'éléments photoémissifs du pixel puis un deuxième alignement selon l'axe Y est réalisé sur les colonnes d'éléments photoémissifs ou inversement.

Dans tous les cas, les commandes de sélection permettent d'aligner électroniquement les éléments photoémissifs 5 et les filtres colorés 3 correspondant, en déterminant quels sont les éléments photoémissifs qui sont effectivement disposés en face du filtre coloré considéré.

## Revendications

1. Dispositif d'affichage, à base d'une matrice de pixels (1), chaque pixel (1) comportant une pluralité de sous-pixels (2) organisés au sein dudit pixel (1) suivant au moins une direction d'organisation avec un pas prédéterminé, chaque sous-pixel (2) comportant un filtre coloré (3) disposé, avec le même pas (P_{F}), en regard d'au moins un élément photoémissif (5), une zone opaque (7) séparant les filtres colorés (3), le dispositif comportant un circuit de commande d'alimentation des éléments photoémissifs (5), dispositif **caractérisé en ce que** chaque sous-pixel (2) comporte au moins deux éléments photoémissifs (5) et **en ce que** les éléments photoémissifs (5) ont un pas de répétition (P_{E}, P_{EX}, P_{EY}) deux fois plus petit que le pas (P_{F}, P_{FX}, P_{FY}) des filtres colorés (3) dans chacune des directions d'organisation du pixel (1), la dimension de chaque filtre coloré (3) étant inférieure ou égale à la dimension de l'élément photoémissif (5) dans ladite direction, le circuit de commande comportant des moyens de sélection des éléments photoémissifs (5) situés en regard de chaque filtre coloré (3) d'un pixel (1).

2. Dispositif selon la revendication 1, **caractérisé en ce que**, dans le pixel (1), les filtres colorés (3) ont une organisation unidimensionnelle et **en ce que** chaque sous-pixel (2) comporte deux éléments photoémissifs (5).

3. Dispositif selon la revendication 1, **caractérisé en ce que**, dans le pixel (1), les filtres colorés (3) ont une organisation bidimensionnelle et **en ce que** chaque sous-pixel (2) comporte quatre éléments photoémissifs (5).

4. Dispositif selon l'une quelconque des revendications 1 à 3, **caractérisé en ce que** les moyens de sélection des éléments photoémissifs comportent autant de commandes de sélection que le sous-pixel (2) comporte d'éléments photoémissifs (5).

5. Dispositif selon l'une quelconque des revendications 1 à 4, **caractérisé en ce que** les commandes de sélection sont associées à une pluralité de lignes et/ou une pluralité de colonnes du dispositif d'affichage.

6. Dispositif selon la revendication 5, **caractérisé en ce que** les commandes de sélection sont associées à toutes les lignes et/ou à toutes les colonnes du dispositif d'affichage.

7. Dispositif selon l'une quelconque des revendications 1 à 4, **caractérisé en ce qu'**à chaque ligne et/ou colonne sont associées des commandes de sélection distinctes.

8. Procédé de réalisation d'un dispositif selon l'une quelconque des revendications 1 à 7, **caractérisé en ce qu'**il comporte successivement :
- la disposition d'une matrice de filtres colorés (3) au-dessus des éléments photoémissifs (5),
- l'alimentation successive des commandes de sélection CS,
- la détermination du désalignement pour chacune des commandes de sélection (CS) et
- la sélection de la commande de sélection (CS) correspondant à un désalignement nul.

## Patentansprüche

1. Anzeigevorrichtung auf der Basis einer Matrix von Pixeln (1), wobei jedes Pixel (1) eine Vielzahl von Subpixeln (2) umfasst, die innerhalb des Pixels (1) entlang wenigstens einer Anordnungsrichtung mit einem vorbestimmten Abstand angeordnet sind, wobei jedes Subpixel (2) ein Farbfilter (3) umfasst, das mit dem gleichen Abstand (P_{F}) gegenüber wenigstens einem Photoemissionselement (5) angeordnet ist, wobei ein opaker Bereich (7) die Farbfilter (3) trennt, wobei die Vorrichtung einen Kreis zur Versorgungssteuerung der Photoemissionselemente (5) umfasst, Vorrichtung, die **dadurch gekennzeichnet ist, dass** jedes Subpixel (2) wenigstens zwei Photoemissionselemente (5) umfasst und dass die Photoemissionselemente (5) einen Wiederholungsabstand (P_{E}, P_{Ex}, P_{EY}) aufweisen, der zweimal kleiner als der Abstand (P_{F}, P_{FX}, P_{FY}) der Farbfilter (3) in jeder der Anordnungsrichtungen des Pixels (1) ist, wobei die Abmessung eines jeden Farbfilters (3) kleiner als die oder gleich der Abmessung des Photoemissionselements (5) in der genannten Richtung ist, wobei der Steuerkreis Mittel zur Auswahl der gegenüber einem jeden Farbfilter (3) eines Pixels (1) gelegenen Photoemissionselemente (5) umfasst.

2. Vorrichtung nach Anspruch 1, **dadurch gekennzeichnet, dass** bei dem Pixel (1) die Farbfilter (3) eine eindimensionale Anordnung aufweisen und dass jedes Subpixel (2) zwei Photoemissionselemente (5) umfasst.

3. Vorrichtung nach Anspruch 1, **dadurch gekennzeichnet, dass** bei dem Pixel (1) die Farbfilter (3) eine zweidimensionale Anordnung aufweisen und dass jedes Subpixel (2) vier Photoemissionselemente (5) umfasst.

4. Vorrichtung nach einem der Ansprüche 1 bis 3, **dadurch gekennzeichnet, dass** die Mittel zur Auswahl der Photoemissionselemente genauso viele Auswahlsteuerungen umfassen wie das Subpixel (2) Photoemissionselemente (5) umfasst.

5. Vorrichtung nach einem der Ansprüche 1 bis 4, **dadurch gekennzeichnet, dass** die Auswahlsteuerungen einer Vielzahl von Zeilen und/oder einer Vielzahl von Spalten der Anzeigevorrichtung zugeordnet sind.

6. Vorrichtung nach Anspruch 5, **dadurch gekennzeichnet, dass** die Auswahlsteuerungen allen Zeilen und/oder allen Spalten der Anzeigevorrichtung zugeordnet sind.

7. Vorrichtung nach einem der Ansprüche 1 bis 4, **dadurch gekennzeichnet, dass** jeder Zeile und/oder Spalte separate Auswahlsteuerungen zugeordnet sind.

8. Verfahren zur Ausbildung einer Vorrichtung nach einem der Ansprüche 1 bis 7, **dadurch gekennzeichnet, dass** es nacheinander umfasst:
- die Anordnung einer Matrix von Farbfiltern (3) oberhalb der Photoemissionselemente (5),
- die sukzessive Versorgung der Auswahlsteuerungen (CS),
- die Festlegung des Versatzes für jede der Auswahlsteuerungen (CS) und
- die Auswahl der Auswahlsteuerung (CS), die einem Null-Versatz entspricht.

## Claims

1. A display device based on a matrix of pixels (1), each pixel (1) comprising a plurality of sub-pixels (2) organized within said pixel (1) in at least one organization direction with a preset pitch, each sub-pixel (2) comprising a color filter (3) arranged, with the same pitch (P_{F}), facing at least one photo-emissive element (5), an opaque area (7) separating the color filters (3), the device comprising a control circuit of the power supply of the photo-emissive elements (5), device **characterized in that** each sub-pixel (2) comprises at least two photo-emissive elements (5) and that the photo-emissive elements (5) have a repetition pitch (P_{E}, P_{EX}, P_{EY}) that is two times smaller than the pitch (P_{F}, P_{FX}, P_{FY}) of the color filters (3) in each of the organization directions of the pixel (1), the size of each color filter (3) being smaller than or equal to the dimension of the photo-emissive element (5) in said direction, the control circuit comprising selection means of the photo-emissive elements (5) located facing each color filter (3) of a pixel (1).

2. The device according to claim 1, **characterized in that**, in the pixel (1), the color filters (3) have a one-dimensional organization and that each sub-pixel (2) comprises two photo-emissive elements (5).

3. The device according to claim 1, **characterized in that**, in the pixel (1), the color filters (3) have a two-dimensional organization and that each sub-pixel (2) comprises four photo-emissive elements (5).

4. The device according to any one of claims 1 to 3, **characterized in that** the means for selecting the photo-emissive elements comprise as many selection commands as the sub-pixel (2) comprises photo-emissive elements (5).

5. The device according to any one of claims 1 to 4, **characterized in that** the selection commands are associated with a plurality of rows and/or a plurality of columns of the display device.

6. The device according to claim 5, **characterized in that** the selection commands are associated with all the rows and/or with all the columns of the display device.

7. The device according to any one of claims 1 to 4, **characterized in that** distinct selection commands are associated with each row and/or column.

8. A method for producing a device according to any one of claims 1 to 7, **characterized in that** it successively comprises:
- arrangement of a matrix of color filters (3) above the photo-emissive elements (5),
- successive supply of the selection commands (CS),
- determination of the misalignment for each of the selection commands (CS), and
- selection of the selection command (CS) corresponding to a zero misalignment.
